# EUROPÄISCHE PATENTSCHRIFT

(11) **EP 2 805 357 B1**
(45) Veröffentlichungstag und Bekanntmachung des Hinweises auf die Patenterteilung: **24.10.2018**
(21) Anmeldenummer: 13702735.5
(22) Anmeldetag: 14.01.2013
(51) Int. Cl.: H01L 31/18, H01L 31/0687, H01L 31/0725

(54) **HALBZEUG EINER MEHRFACHSOLARZELLE UND VERFAHREN ZUR HERSTELLUNG EINER MEHRFACHSOLARZELLE**
SEMIFINISHED PRODUCT OF A MULTI-JUNCTION SOLAR CELL AND METHOD FOR PRODUCING A MULTI-JUNCTION SOLAR CELL
PRODUIT SEMI-FINI D'UNE CELLULE SOLAIRE MULTIJONCTION ET PROCÉDÉ DE FABRICATION D'UNE CELLULE SOLAIRE MULTIJONCTION

(30) Priorität: 20.01.2012 EP 12000386
(43) Veröffentlichungstag der Anmeldung: 26.11.2014
(73) Patentinhaber: AZURSPACE Solar Power GmbH, 74072 Heilbronn (DE)
(72) Erfinder: FUHRMANN, Daniel, 74074 Heilbronn (DE)
(74) Vertreter: Koch Müller Patentanwaltsgesellschaft mbH
(86) Internationale Anmeldenummer: PCT/EP2013/000096
(87) Internationale Veröffentlichungsnummer: WO 2013/107628

(56) Entgegenhaltungen:
- WO-A1-2004/054003
- DE-A1-102008 019 268
- FR-A1- 2 954 002
- US-A1- 2011 155 231

## Beschreibung

Die Erfindung betrifft ein Halbzeug einer Mehrfachsolarzelle gemäß dem Oberbegriff des Patentanspruchs 1 und ein Verfahren zur Herstellung einer Solarzelle gemäß dem Oberbegriff des Patentanspruchs 9.
Aus der US 4 774 194 ist ein Verfahren zur Ablösung von III-V-basierten Solarzellschichten von einem Trägersubstrat mittels selektiven chemischen Ätzprozessen bekannt. Des Weiteren sind aus der US 4 883 561 und aus der US 2010/0116784 A1 Verfahren zur Trennung von Halbleiterschichten von deren Trägersubstraten auf Basis von chemischen Ätzprozessen bekannt. Die Trennung von Halbleiterschichten mittels des Verfahrens der Ionenimplantation ist aus der US 5 374 564 bekannt. Weiterhin sind optische Verfahren zur Trennung von Halbleitermaterialien, insbesondere von LED-Schichten auf Basis der Gruppe III Nitride von Substraten mit großer Bandlücke, aus der DE 196 49 594 A1 und der US 6 071 795 bekannt. Ferner ist aus der US 7 785 989 B2 eine weitere Solarzellenstruktur bekannt.

Aus der US 2011/155231 sowie aus der DE 10 2008 019268 ist ein Halbzeug einer Mehrfachsolarzelle mit einer Opferschicht bekannt. Vor diesem Hintergrund besteht die Aufgabe der Erfindung darin, eine Vorrichtung anzugeben, die den Stand der Technik weiterbildet.
Die Aufgabe wird durch ein Halbzeug einer Mehrfachsolarzelle mit den Merkmalen des Patentanspruchs 1 und durch ein Verfahren zur Herstellung einer Solarzelle gemäß dem Oberbegriff des Patentanspruchs 9 gelöst. Vorteilhafte Ausgestaltungen der Erfindung sind Gegenstand von Unteransprüchen.
Gemäß dem ersten Gegenstand der Erfindung wird ein Halbzeug einer Mehrfachsolarzelle bereitgestellt, mit einem als eine erste Teilsolarzelle ausgebildeten Halbleiterkörper, aufweisend einen ersten Bandabstand, mit einem als einer zweiten Teilsolarzelle ausgebildeten Halbleiterkörper aufweisend einen zweiten Bandabstand, wobei der erste Halbleiterkörper und der zweite Halbleiterkörper eine stoffschlüssige Verbindung mit einer Tunneldiode ausbilden und der erste Bandabstand unterschiedlich zu dem zweiten Bandabstand ausgebildet ist und einem als Substratschicht ausgebildeten ersten Trägermaterial, wobei zwischen dem ersten Trägermaterial und der ersten Teilsolarzelle eine Opferschicht ausgebildet ist und das erste Trägermaterial unter Zerstörung der Opferschicht von dem ersten Halbleiterkörper entfernt wird. Es sei angemerkt, dass die beiden Teilsolarzellen stapelförmig angeordnet sind und als Teilsolarzelle ein Halbleiterkörper bezeichnet wird, der als einzelner Halbleiterkörper aus der Energie der einfallenden Photonen eines bestimmten Bereichs des Sonnenspektrums elektrische Energie durch direkte Konversion erzeugt. Die Empfindlichkeitsbereiche der Teilsolarsolarzellen sind so gewählt, dass alle Teilsolarzellen zusammen das Sonnenspektrum möglichst ideal ausnutzen. Mit dem Konzept der gestapelten Mehrfachsolarzelle können heute Konversionseffizienzen bis 40% erreicht werden. Des Weiteren sei angemerkt, dass bei dem Ablösen von dem Substrat vorzugsweise ausschließlich die Opferschicht zerstört wird.

Gemäß dem zweiten Gegenstand der Erfindung wird ein Verfahren zur Herstellung einer Mehrfachsolarzelle bereitgestellt, mit einem als Substratschicht ausgebildeten ersten Trägermaterial, wobei ein als eine erste Teilsolarzelle ausgebildeter Halbleiterkörper, mit einem ersten Bandabstand hergestellt wird, und ein als eine zweite Teilsolarzelle ausgebildeter Halbleiterkörper mit einem zweiten Bandabstand hergestellt wird, wobei zwischen dem ersten Halbleiterkörper und dem zweiten Halbleiterkörper eine stoffschlüssige Verbindung mit einer Tunneldiode ausgebildet wird, und der erste Bandabstand unterschiedlich zu dem zweiten Bandabstand ausgebildet wird, wobei zwischen dem ersten Trägermaterial und der ersten Teilzelle eine Opferschicht hergestellt wird und in einem nachfolgenden Verfahrensschritt das erste Trägermaterial unter Zerstörung der Opferschicht von dem ersten Halbleiterkörper entfernt wird.

Ein Vorteil der Opferschicht auf dem Substrat ist es, dass sich die stapelförmige Mehrfachsolarzelle von dem Substrat auf einfache und kostengünstige Weise ablösen lässt. Mittels des Ablöseprozesses lässt sich die Mehrfachsolarzelle von dem Substrat ohne Beschädigung weder des Substrats noch der Mehrfachsolarzelle trennen. Vorteilhaft ist, nach dem Ablösen eventuelle Reste der Opferschicht auf dem Substrat oder der ersten Teilsolarzelle mittels eines Reinigungsprozess zu entfernen. Des Weiteren ist es vorteilhaft, dass nach dem Ablösen der Substratschicht weitere Teilsolarzellen auf die Mehrfachsolarzelle aufgebracht werden können und hierdurch hocheffiziente Mehrfachsolarzellen bestehend aus einem Stapel von 3, 4 oder mehr Teilsolarzellen hergestellt werden können. Unter hocheffiziente Solarzelle werden Solarzellen verstanden, welche einen Konversionskoeffizient oberhalb 25 % aufweisen.
Es ist bevorzugt, die gestapelte Mehrfachsolarzelle als III-V Solarzelle, d.h. als Solarzelle bestehend aus Verbindungshalbleitern der 3. und 5. Hauptgruppe des Periodensystems, auszuführen. Ferner lässt sich das Substrat für eine Herstellung von Mehrfachsolarzellen wiederverwenden. Indem die Substrate sehr kostenintensiv sind, lassen sich die Herstellungskosten durch die Wiederverwendung der Substrate stark reduzieren. Ein weiterer Vorteil der neuen Abtrenntechnik ist es, dass sich das Ablösen nunmehr sehr schnell und zuverlässig ausführen lässt. Untersuchungen haben gezeigt, dass sich das neue Verfahren bzw. der neuartige Aufbau besonders vorteilhaft auf Mehrfachsolarzellen für Weltraumanwendungen, die eine typische Größe von 8 cm x 4 cm oder größer aufweisen, anwenden lässt. Ferner ist es auch vorteilhaft den neuartigen Ablöseprozess zur Herstellung von Mehrfachsolarzellen, deren Größe unterhalb von 8cm x 4cm vorzugsweise in einem Bereich von 1 mm² bis 400 mm², liegt, anzuwenden. Derartige Mehrfachsolarzellen mit einer geringen Größe lassen sich bevorzugt in terrestrischen Konzentratorsystemen verwenden.
Besonders vorteilhaft lässt sich die Opferschicht derart ausführen, dass sich die Opferschicht unter Absorption elektromagnetischer Energie lokal erhitzen lässt. Mittels der so auftretenden thermisch bedingten Zersetzung der Opferschicht lässt sich das Substrat leicht von dem Solarzellenstapel trennen. Hierdurch werden der Durchsatz und die Ausbeute in der Produktion erhöht und die Herstellungskosten gesenkt.
Zur thermisch induzierten Zersetzung der Opferschicht aufgrund der Absorption elektromagnetischer Strahlung weist die Opferschicht einen Bandabstand mit einer Energie kleiner als 1,2 eV, auf. Hierdurch ist die Opferschicht nicht transparent für sichtbares Licht und besitzt eine Absorptionsbande im infraroten Spektralbereich. Idealerweise, aber nicht notwendigerweise, besitzt die Opferschicht die kleinste Bandlückenenergie aller Schichten der gestapelten Mehrfachsolarzelle. Sofern die anderen Schichten der gestapelten Mehrfachsolarzelle, d. h. insbesondere der Stapel aus dem ersten Halbleiterkörper und dem zweiten Halbleiterkörper, transparent für die vorzugsweise im infraroten Wellenlängenbereich eingestrahlte elektromagnetische Strahlung ausgebildet sind, wird hierdurch gewährleistet, dass die durch den Stapel aus dem ersten Halbleiterkörper und dem zweiten Halbleiterkörper eingestrahlte elektromagnetische Energie nur in der Opferschicht absorbiert wird. Vorteilhaft ist es, die Bandlückenenergie der Opferschicht und die Energie der einfallenden elektromagnetischen Strahlung aufeinander abzustimmen. Untersuchungen haben gezeigt, dass es vorteilhaft ist, die Absorptionsbande der Opferschicht auf die Wellenlänge einer infraroten Lasereinrichtung, mit einem gepulsten Laser mit einer Energie von etwa 1,16 eV beispielsweise ein Nd-YAG Laser mit einer Wellenlänge von 1064 nm abzustimmen. Hierzu wird die Bandlückenenergie der Opferschicht auf einen Wert von ≤ 1,15 eV eingestellt.
Untersuchungen haben gezeigt, dass sich je nach Art des Substrates unterschiedliche Materialien für die Opferschicht eignen. Besonders vorteilhaft lässt sich, ausgehend von einem GaAs-Substrat, einem InP-Substrat oder einem Ge-Substrat, die Opferschicht aus InAs, GaAs, InSb, GaSb, InP beziehungsweise deren ternären und quaternären Mischhalbleitern ausbilden. Aufgrund der niedrigen Bandlücke von Ge eignet sich für eine Mehrfachsolarzelle auf einem GaAs- oder einem InP-Substrat insbesondere eine epitaxierte Ge-Opfersschicht. Vorteilhaft ist es, die Opferschicht in einer Dicke zwischen 10nm und 200nm auszubilden.
Gemäß einer Weiterbildung weist die Opferschicht eine zu der Gitterkonstante der ersten Teilsolarzelle unterschiedliche Gitterkonstante auf. Untersuchungen haben gezeigt, dass es vorteilhaft ist die Opferschicht gitterfehlangepasst auf dem Substrat abzuscheiden.

In einer alternativen Ausführungsform ist die Opferschicht zu der ersten Teilsolarzelle gitterangepasst. Hierbei wird bei der Herstellung der Opferschicht die Gitterkonstante im Wesentlichen gleich mit der ersten Teilsolarzelle gewählt.

Untersuchungen haben gezeigt, dass es gemäß einer Weiterbildung besonders vorteilhaft ist, wenn zwischen der Opferschicht und der ersten Teilsolarzelle eine Pufferschicht ausgebildet ist und die Pufferschicht eine stoffschlüssige Verbindung mit der ersten Teilsolarzelle aufweist. Insbesondere bei dem Ablösen wirkt die Pufferschicht als zusätzliche Schutzschicht und unterdrückt eine Beschädigung des ersten Halbleiterkörpers. Untersuchungen haben gezeigt, dass es vorteilhaft ist, die Pufferschicht gitterangepasst, d. h. die Gitterkonstante der Pufferschicht vergleichbar mit der Gitterkonstante der ersten Teilsolarzelle zu wählen. Insbesondere ist es vorteilhaft die Dicke der Pufferschicht zwischen 100 nm und 2 µm zu wählen, höchst vorzugsweise wird die Dicke der Pufferschicht mit 500nm gewählt.

Gemäß einer anderen Weiterbildung ist die Pufferschicht als Bragg-Spiegel ausgebildet. Hierdurch wird bewirkt, dass Licht, welches nicht in dem ersten Halbleiterkörper absorbiert wird, wieder in den ersten Halbleiterkörper zurückreflektiert wird. Hierdurch lässt sich der Wirkungsgrad der Mehrfachsolarzelle erhöhen.

Gemäß einer Ausführungsform ist auf der zweiten Teilsolarzelle eine mit der zweiten Teilsolarzelle stoffschlüssig verbundene Tragschicht angeordnet. Untersuchungen haben gezeigt, dass nach dem Ablösen des Substrats die Tragschicht die Solarzelle mechanisch stabilisiert, insbesondere wenn nach dem Ablösen auf die erste Teilsolarzelle wenigstens eine weitere Teilsolarzelle zur Ausbildung einer Mehrfachsolarzelle bestehend aus 3, 4 oder mehr Teilsolarzellen aufgebracht wird.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:

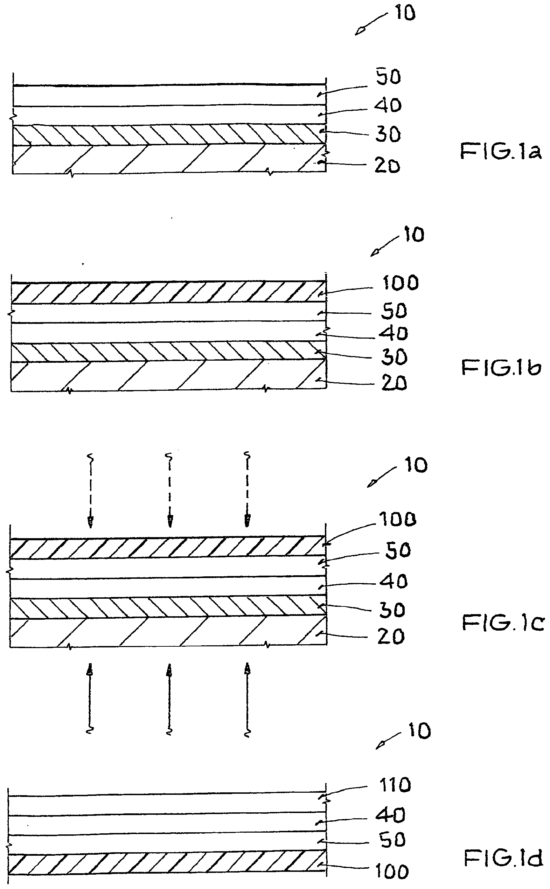

- Figur 1a - 1d: einen Querschnitt auf unterschiedliche Ausführungsformen und Herstellungsschritte von einem Halbzeug einer Mehrfachsolarzelle.

Die Abbildung der Figur 1a zeigt einen schematischen Querschnitt eines Halbzeugs mit einer stapelförmigen Anordnung einer Mehrfachsolarzelle 10, aufweisend eine Substratschicht 20, eine Opferschicht 30, einen ersten Halbleiterkörper 40 und einen mit dem ersten Halbleiterkörper 40 stoffschlüssig verbundenen zweiten Halbleiterkörper 50. Zwischen dem ersten Halbleiterkörper 40 und dem zweiten Halbleiterkörper 50 ist eine Tunneldiode ausgebildet. Die Opferschicht ist vorzugsweise mit dem aufliegenden ersten Halbleiterkörper 40 verbunden. Vorzugsweise ist die Mehrfachsolarzelle als eine III-V Solarzelle, insbesondere unter Verwendung von InGaAs und InGaP, ausgebildet. Des Weiteren ist der erste Halbleiterkörper 40 als erste Teilsolarzelle und der zweite Halbleiterkörper 50 als zweite Teilsolarzelle ausgebildet, wobei die erste Teilsolarzelle einen ersten Bandabstand und die zweite Teilsolarzelle einen zweiten von dem ersten Bandabstand unterschiedlichen Bandabstand aufweist. Des Weiteren weist die Opferschicht einen dritten Bandabstand auf, wobei der dritte Bandabstand kleiner gewählt ist, als der erste Bandabstand und der zweite Bandabstand. Außerdem besteht die Substratschicht aus einem Trägermaterial mit einem vierten Bandabstand, wobei der vierte Bandabstand vorzugsweise kleiner als 1,6 eV und vorzugsweise größer als der dritte Bandabstand ist.

In der Abbildung der Figur 1b ist eine zweite Ausführungsform eines Halbzeugs dargestellt. Im Folgenden werden nur die Unterschiede zur Ausführungsform dargestellt in der Abbildung der Figur 1a erläutert. Auf dem zweiten Halbleiterkörper 50 ist eine Tragschicht 100 ausgebildet. Die Tragschicht lässt sich besonders vorteilhaft auch als Kunststofffolie ausbilden und dient zur mechanischen Stabilisierung des Stapels aus erstem und zweitem Halbleiterkörper 40 und 50 nach der Ablösung.

In der Abbildung der Figur 1c ist ein weiterbildender Prozessschritt des Halbzeugs von der Figur 1b dargestellt. Im Folgenden werden nur die Unterschiede zu Ausführungsformen dargestellt in einer der vorangegangen Figuren erläutert. Die Opferschicht 30 wird mittels Infrarotstrahlung, vorzugsweise mittels eines Infrarotlasers erhitzt und zersetzt. Hierbei wird die Wellenlänge der Strahlung an das Absorptionsvermögen der Opferschicht 30 angepasst. Untersuchungen haben gezeigt, dass die Einstrahlung des Lichtes sowohl durch die Vorderseite der Mehrfachsolarzelle, d.h. durch den Stapel aus dem erstem und dem zweiten Halbleiterkörper 40 und 50 hindurch, oder alternativ durch die Substratschicht 20 erfolgt. Bei Bestrahlung durch die Vorderseite ist es in einer Ausführungsform vorteilhaft, wie in Abbildung der Figur 1c dargestellt, die Tragschicht 100 bereits vor der Bestrahlung aufzubringen, sofern die Tragschicht 100 transparent für die Wellenlänge des infraroten Lasers ist. Gemäß einer alternativen Ausführungsform ist es vorteilhaft, die Tragschicht 100 erst nach der Bestrahlung mit Infrarotlicht aufzubringen. Hierbei erfolgt die Bestrahlung des Halbzeugs gemäß der in der Figur 1a dargestellten Ausführungsform, durch die Vorderseite und oder durch die Rückseite. Die nach der Bestrahlung aufgebrachte Tragschicht lässt sich anschließend insbesondere für das Abheben der Mehrfachsolarzelle vom Substrat 20 verwenden.

Gemäß einer Weiterbildung ist es besonders vorteilhaft, die Opferschicht 30 gleichzeitig durch die Vorderseite, d.h. durch die Halbleiterkörper 40 und 50 mit oder ohne Tragschicht 100, und durch die Substratschicht 20 zu bestrahlen. Durch die Einstrahlung mit Licht wird die Opferschicht 30 stark erwärmt. Hierbei wird unter Zerstörung der Opferschicht 30 die Mehrfachsolarzelle von der Substratschicht 20 gelöst.

In der Abbildung der Figur 1d ist ein weiterbildender Prozessschritt des Halbzeugs von der Figur 1c dargestellt. Im Folgenden werden nur die Unterschiede zu Ausführungsformen dargestellt in einer der vorangegangen Figuren erläutert. Nach dem vollständigen Entfernen der Opferschicht 30 wird die Mehrfachsolarzelle umgedreht und auf dem ersten Halbleiterkörper 40 wird ein dritter Halbleiterkörper 110 ausgebildet. Es sei angemerkt, dass der dritte Halbleiterkörper 110 ebenfalls als III-V Verbindung ausgebildet ist.

## Patentansprüche

1. Halbzeug einer Mehrfachsolarzelle (10) mit,
- einem als eine erste Teilsolarzelle ausgebildeten Halbleiterkörper (40), mit einem ersten Bandabstand,
- einem als einer zweiten Teilsolarzelle ausgebildeten Halbleiterkörper (50) mit einem zweiten Bandabstand, wobei der erste Halbleiterkörper (40) und der zweite Halbleiterkörper (50) eine stoffschlüssige Verbindung mit einer Tunneldiode ausbilden, und
der erste Bandabstand unterschiedlich zu dem zweiten Bandabstand ausgebildet ist,
- einem als Substratschicht (20) ausgebildeten ersten Trägermaterial, und zwischen dem ersten Trägermaterial und der ersten Teilsolarzelle eine Opferschicht (30) ausgebildet ist,
wobei die Substratschicht (20) als GaAs oder InP oder Ge-Substrat ausgebildet ist, und
die Opferschicht (30) einen dritten Bandabstand aufweist,
**dadurch gekennzeichnet, dass**
der dritte Bandabstand kleiner als der erste Bandabstand und kleiner als
der zweite Bandabstand ist, und wobei
der dritte Bandabstand kleiner als 1,2 eV ist, und
der Stapel aus dem ersten Halbleiterkörper [40] und dem zweiten Halbleiterkörper [50] transparent für eine im infraroten Wellenlängenbereich eingestrahlte elektromagnetische Strahlung ausgebildet ist, und
die Opferschicht (30) eine Absorptionsbande im infraroten Spektralbereich aufweist, so dass
die durch den Stapel eingestrahlte elektromagnetische Energie nur in der Opferschicht absorbiert wird, um
das erste Trägermaterial unter Zerstörung der Opferschicht von dem ersten Halbleiterkörper zu entfernen.

2. Halbzeug nach Anspruch 1, **dadurch gekennzeichnet, dass** die Opferschicht (30) eine zu der Gitterkonstante der ersten Teilsolarzelle unterschiedliche Gitterkonstante aufweist.

3. Halbzeug nach Anspruch 1, **dadurch gekennzeichnet, dass** die Opferschicht (30) gitterangepasst zu der ersten Teilsolarzelle ist.

4. Halbzeug nach einem der vorstehenden Ansprüche, **dadurch gekennzeichnet, dass** die Substratschicht (20) eine Bandlücke mit einer Energie kleiner als 1.5 eV aufweist.

5. Halbzeug nach einem der vorstehenden Ansprüche, **dadurch gekennzeichnet, dass** die zweiten Teilsolarzelle eine mit der zweiten Teilsolarzelle stoffschlüssig verbundene Tragschicht aufweist.

6. Halbzeug nach Anspruch 1, **dadurch gekennzeichnet, dass** zwischen der Opferschicht (30) und der ersten Teilsolarzelle eine Pufferschicht ausgebildet ist und die Pufferschicht eine stoffschlüssige Verbindung zu der ersten Teilsolarzelle aufweist.

7. Halbzeug nach Anspruch 6, **dadurch gekennzeichnet, dass** die Pufferschicht als Bragg-Spiegel ausgebildet ist.

8. Halbzeug nach einem der vorstehenden Ansprüche, **dadurch gekennzeichnet, dass** auf der zweiten Teilsolarzelle eine mit der zweiten Teilsolarzelle stoffschlüssig verbundene Tragschicht (100) angeordnet ist.

9. Verfahren zur Herstellung einer Mehrfachsolarzelle (10), mit
- einem als Substratschicht (20) ausgebildeten ersten Trägermaterial, wobei
- ein als eine erste Teilsolarzelle ausgebildeter Halbleiterkörper (40), mit einem ersten Bandabstand hergestellt wird,
- ein als eine zweite Teilsolarzelle ausgebildeter Halbleiterkörper (50) mit einem zweiten Bandabstand hergestellt wird, wobei zwischen dem ersten Halbleiterkörper (40) und dem zweiten Halbleiterkörper (50) eine stoffschlüssige Verbindung mit einer Tunneldiode ausgebildet wird, und
der erste Bandabstand unterschiedlich zu dem zweiten Bandabstand ausgebildet wird, und
zwischen dem ersten Trägermaterial und der ersten Teilzelle eine Opferschicht (30) hergestellt wird, wobei
die Substratschicht (20) aus einem GaAs oder einem InP oder einem Ge-Substrat ausgebildet wird,
**dadurch gekennzeichnet, dass** die Opferschicht (30) mit einem dritten Bandabstand von kleiner als 1,2 eV ausgebildet wird, wobei der dritte Bandabstand kleiner als der erste Bandabstand und kleiner als der zweite Bandabstand ist, und der Stapel aus dem ersten Halbleiterkörper (40) und dem zweiten Halbleiterkörper (50) für eine im infraroten Wellenlängenbereich eingestrahlte elektromagnetische Strahlung transparent ausgebildet wird, und
in einem nachfolgenden Verfahrensschritt das erste Trägermaterial unter Zerstörung der Opferschicht (30) von dem ersten Halbleiterkörper (40) zerstört wird, indem die durch den Stapel aus dem ersten Halbleiterkörper (40) und dem zweiten Halbleiterkörper (50) eingestrahlte elektromagnetische Strahlung in der Opferschicht (30) absorbiert wird.

10. Verfahren nach Anspruch 9, **dadurch gekennzeichnet, dass** zwischen der Opferschicht (30) und der ersten Teilsolarzelle eine stoffschlüssig mit der ersten Teilsolarzelle verbundene Pufferschicht hergestellt wird.

11. Verfahren nach Anspruch 10, **dadurch gekennzeichnet, dass** die Pufferschicht als Bragg-Spiegel ausgebildet wird.

12. Verfahren nach Anspruch 10 oder Anspruch 11, **dadurch gekennzeichnet, dass** auf der zweiten Teilsolarzelle eine mit der zweiten Teilsolarzelle stoffschlüssig verbundene Tragschicht (100) angeordnet wird.

13. Verfahren nach einem der Ansprüche 9 bis 12, **dadurch gekennzeichnet, dass** die Opferschicht (30) mittels der Absorption einer elektromagnetischen Welle erhitzt und zersetzt wird und die erste Teilsolarzelle und die zweite Teilsolarzelle gemeinsam von der Opferschicht (30) abgelöst werden.

14. Verfahren nach einem der Ansprüche 9 bis 13, **dadurch gekennzeichnet, dass** auf der ersten Teilsolarzelle oder der zweiten Teilsolarzelle eine weitere Einfachsolarzelle oder eine weitere Mehrfachsolarzelle ausgebildet wird und die weitere Einfachsolarzelle oder die weitere Mehrfachsolarzelle einen zur ersten Teilsolarzelle und zur zweiten Teilsolarzelle unterschiedlichen Bandabstand aufweist.

## Claims

1. Semi-finished product of a multiple solar cell (10), comprising
- a semiconductor body (40), which is formed as a first part solar cell, with a first band spacing,
- a semiconductor body (50), which is formed as a second part solar cell, with a second band spacing, wherein the first semiconductor body (40) and the second semiconductor body (50) form a connection by material couple with a tunnel diode and the first band spacing is formed to be different from the second band spacing,
- a first carrier material formed as a substrate layer (20) and
- a sacrificial layer (30) formed between the first carrier material and the first part solar cell,
wherein the substrate layer (20) is formed as a GaAs or InP or Ge substrate and the sacrificial layer (30) has a third band spacing,
**characterised in that**
the third band spacing is smaller than the first band spacing and smaller than the second band spacing,
the third band spacing is smaller than 1.2 eV,
the stack consisting of the first semiconductor body (40) and the second semiconductor body (50) is formed to be transparent to electromagnetic radiation radiated-in in the infrared wavelength range and
the sacrificial layer (30) has an absorption band in the infrared spectral range so that the electromagnetic radiation radiated-in through the stack is absorbed only in the sacrificial layer so as to distance the first carrier material from the first semiconductor body under destruction of the sacrificial layer.

2. Semi-finished product according to claim 1, **characterised in that** the sacrificial layer (30) has a lattice constant different from the lattice constant of the first part solar cell.

3. Semi-finished product according to claim 1, **characterised in that** sacrificial layer (30) is matched in terms of lattice to the first part solar cell.

4. Semi-finished product according to any one of the preceding claims, **characterised in that** the substrate layer (20) has a band width with an energy smaller than 1.5 eV.

5. Semi-finished product according to any one of the preceding claims, **characterised in that** the second part solar cell has a carrier layer connected with the second part solar cell by material couple.

6. Semi-finished product according to claim 1, **characterised in that** a buffer layer is formed between the sacrificial layer (30) and the first part solar cell and the buffer layer has a material-coupling connection with the first part solar cell.

7. Semi-finished product according to claim 6, **characterised in that** the buffer layer is formed as a Bragg reflector.

8. Semi-finished product according to any one of the preceding claims, **characterised in that** a carrier layer (100) connected by material couple with the second part solar cell is arranged on the second part solar cell.

9. Method of producing a multiple solar cell (10), comprising
- a first carrier material formed as a substrate layer (20), wherein
- a semiconductor body (40), which is formed as a first part solar cell, is produced with a first band spacing,
- a semiconductor body (50), which is formed as a second part solar cell, is produced with a second band spacing, wherein a connection by material couple with the tunnel diode is formed between the first semiconductor body (40) and the second semiconductor body (50) and
the first band spacing is formed to be different from the second band spacing and
- a sacrificial layer (30) is produced between the first carrier material and the first part cell,
wherein the substrate layer (20) is formed from a GaAs or an InP or a GE substrate, **characterised in that**
the sacrificial layer (30) is formed with a third band spacing of less than 1.2 eV, wherein the third band spacing is smaller than the first band spacing and smaller than the second band spacing, and the stack consisting of the first semiconductor body (40) and the second semiconductor body (50) is constructed to be transparent to electromagnetic radiation radiated-in in the infrared wavelength range, and
in a subsequent method step the first carrier material is distanced from the first semiconductor body (40) under destruction of the sacrificial layer (30) **in that** the electromagnetic radiation radiated-in through the stack consisting of the first semiconductor body (40) and the second semiconductor body (50) is absorbed in the sacrificial layer (30).

10. Method according to claim 9, **characterised in that** a buffer layer connected by material couple with the first part solar cell is produced between the sacrificial layer (30) and the first solar cell.

11. Method according to claim 10, **characterised in that** the buffer layer is constructed as a Bragg reflector.

12. Method according to claim 10 or claim 11, **characterised in that** a carrier layer (100) connected with the second part solar cell by material couple is arranged on the second part solar cell.

13. Method according to any one of claims 9 to 12, **characterised in that** the sacrificial layer (30) is heated and destroyed by means of absorption of an electromagnetic wave and the first part solar cell and the second part solar cell are together detached from the sacrificial layer (30).

14. Method according to any one of claims 9 to 13, **characterised in that** a further single solar cell or a further multiple solar cell is formed on the first part solar cell of the second part solar cell and the further, single solar cell or the further, multiple solar cell has a band spacing different from the first part solar cell and from the second part solar cell.

## Revendications

1. Produit semi-fini d'une cellule solaire multijonction (10), avec
- un corps semi-conducteur (40) réalisé sous la forme d'une première cellule solaire partielle, avec une première largeur de bande interdite,
- un corps semi-conducteur (50) réalisé sous la forme d'une deuxième cellule solaire partielle avec une deuxième largeur de bande interdite, dans lequel le premier corps semi-conducteur (40) et le deuxième corps semi-conducteur (50) forment une liaison matérielle avec une diode tunnel, et la première largeur de bande interdite est réalisée différemment de la deuxième largeur de bande interdite, et
- un premier matériau de support réalisé sous la forme d'une couche de substrat (20), et une couche sacrificielle (30) est formée entre le premier matériau de support et la première cellule solaire partielle,
dans lequel la couche de substrat (20) est réalisée sous forme de substrat de GaAs ou InP ou Ge, et la couche sacrificielle (30) présente une troisième largeur de bande interdite,
**caractérisé en ce que** la troisième largeur de bande interdite est plus petite que la première largeur de bande interdite et plus petite que la deuxième largeur de bande interdite, et dans lequel la troisième largeur de bande interdite est inférieure à 1,2 eV, et la pile constituée du premier corps semi-conducteur (40) et du deuxième corps semi-conducteur (50) est transparente pour un rayonnement électromagnétique irradié dans le domaine de longueurs d'onde infrarouge, et la couche sacrificielle (30) présente une bande d'absorption dans le domaine spectral infrarouge, de telle manière que l'énergie électromagnétique irradiée à travers la pile ne soit absorbée que dans la couche sacrificielle, afin d'enlever le premier matériau de support du premier corps semi-conducteur par destruction de la couche sacrificielle.

2. Produit semi-fini selon la revendication 1, **caractérisé en ce que** la couche sacrificielle (30) présente une constante de réseau différente de la constante de réseau de la première cellule solaire partielle.

3. Produit semi-fini selon la revendication 1, **caractérisé en ce que** la couche sacrificielle (30) est adaptée au niveau du réseau à la première cellule solaire partielle.

4. Produit semi-fini selon l'une quelconque des revendications précédentes, **caractérisé en ce que** la couche de substrat (20) présente une bande interdite avec une énergie inférieure à 1,5 eV.

5. Produit semi-fini selon l'une quelconque des revendications précédentes, **caractérisé en ce que** la deuxième cellule solaire partielle présente une couche de support assemblée matériellement à la deuxième cellule solaire partielle.

6. Produit semi-fini selon la revendication 1, **caractérisé en ce qu'**une couche tampon est formée entre la couche sacrificielle (30) et la première cellule solaire partielle et la couche tampon présente un assemblage matériel avec la première cellule solaire partielle.

7. Produit semi-fini selon la revendication 6, **caractérisé en ce que** la couche tampon est réalisée sous forme de miroir de Bragg.

8. Produit semi-fini selon l'une quelconque des revendications précédentes, **caractérisé en ce qu'**une couche de support (100) assemblée matériellement à la deuxième cellule solaire partielle est disposée sur la deuxième cellule solaire partielle.

9. Procédé de fabrication d'une cellule solaire multijonction (10), avec
- un premier matériau de support réalisé sous forme de couche de substrat (20),
- on fabrique un corps semi-conducteur (40) réalisé sous la forme d'une première cellule solaire partielle, avec une première largeur de bande interdite,
- on fabrique un deuxième corps semi-conducteur (50) réalisé sous la forme d'une deuxième cellule solaire partielle, avec une deuxième largeur de bande interdite, dans lequel on forme entre le premier corps semi-conducteur (40) et le deuxième corps semi-conducteur (50) une liaison matérielle avec une diode tunnel, et on réalise la première largeur de bande interdite différemment de la deuxième largeur de bande interdite, et on fabrique une couche sacrificielle (30) entre le premier matériau de support et la première cellule solaire partielle, dans lequel on réalise la couche de substrat (20) sous la forme d'un substrat en GaAs, InP ou Ge,
**caractérisé en ce que**
on réalise la couche sacrificielle (30) avec une troisième largeur de bande interdite de moins de 1,2 eV, dans lequel la troisième largeur de bande interdite est plus petite que la première largeur de bande interdite et plus petite que la deuxième largeur de bande interdite, et on réalise la pile constituée du premier corps semi-conducteur (40) et du deuxième corps semi-conducteur (50) de façon transparente pour un rayonnement électromagnétique irradié dans le domaine de longueurs d'onde infrarouge, et
dans une étape de procédé suivante, on détruit le premier matériau de support du premier corps semi-conducteur (40) par destruction de la couche sacrificielle (30),
du fait que le rayonnement électromagnétique irradié à travers la pile constituée du premier corps semi-conducteur (40) et du deuxième corps semi-conducteur (50) est absorbé dans la couche sacrificielle (30).

10. Procédé selon la revendication 9, **caractérisé en ce que** l'on fabrique entre la couche sacrificielle (30) et la première cellule solaire partielle une couche tampon assemblée matériellement à la première cellule solaire partielle.

11. Procédé selon la revendication 10, **caractérisé en ce que** l'on réalise la couche tampon sous forme de miroir de Bragg.

12. Procédé selon la revendication 10 ou la revendication 11, **caractérisé en ce que** l'on dispose sur la deuxième cellule solaire partielle une couche de support (100) assemblée matériellement à la deuxième cellule solaire partielle.

13. Procédé selon l'une quelconque des revendications 9 à 12, **caractérisé en ce que** l'on chauffe et on décompose la couche sacrificielle (30) par le biais de l'absorption d'une onde électromagnétique et la première cellule solaire partielle et la deuxième cellule solaire partielle sont débarrassées en commun de la couche sacrificielle (30).

14. Procédé selon l'une quelconque des revendications 9 à 13, **caractérisé en ce que** l'on forme sur la première cellule solaire partielle ou sur la deuxième cellule solaire partielle une autre cellule solaire à jonction unique ou une autre cellule solaire multijonction et l'autre cellule solaire à jonction unique ou l'autre cellule solaire multijonction présente une largeur de bande interdite différente de la première cellule solaire partielle et de la deuxième cellule solaire partielle.
